# EUROPEAN PATENT APPLICATION

(11) **EP 2 899 653 A1**
(43) Date of publication of application: **29.07.2015**
(21) Application number: 14152891.9
(22) Date of filing: 28.01.2014
(51) Int. Cl.: G06F 17/50

(54) **Method, system and computer program product for characterizing the variability of an integrated circuit design**

(71) Applicant: IMEC VZW, 3001 Leuven (BE)
(72) Inventor: Christie, Philip, 3001 Leuven (BE); Dobrovolny, Petr, 3001 Leuven (BE); Zuber, Paul, 3001 Leuven (BE)
(74) Representative: Sarlet, Steven Renaat Irène

(57) **Abstract**

A method for characterizing the variability of a given IC design in a target semiconductor manufacturing process comprising: providing a timing report of said integrated circuit design from an existing description of said integrated circuit design comprising: semiconductor manufacturing process independent design information comprising a data path structure comprising a sequence of standard cells and nets interconnecting said standard cells, and semiconductor manufacturing process dependent design information comprising delay values and the capacitance values, of the standard cells and interconnecting nets in the data path structure; creating a functionalized timing trace for data paths by using the semiconductor manufacturing process independent design; determining a path delay statistical distribution for each said functionalized timing trace, by applying substitute semiconductor manufacturing process dependent design information comprising: statistical distributions of delay values and capacitance values determined by statistical characterization of the respective standard cells in the respective data path to account transistor variability.

## Description

### Technical field

The present disclosure relates to in general to the design of integrated circuits, and more in particular to a method, system and computer program product for characterizing the variability of a given integrated circuit design in a target semiconductor manufacturing process.

### Background art

With improvements in technology, there has been continuous scaling of semiconductor device features due to improvements in design of semiconductor chips. Scaling of semiconductor devices has been driven by reductions in performance parameters such as switching delay, leakage and dynamic power dissipation. The scaling of semiconductor devices has an additional benefit that the cost per product is considerably reduced with each technology node since more functionality can be packed in less area. However, this is true when product yield is maintained above a certain threshold, which becomes increasingly difficult with advent of each semiconductor technology node. To ensure that the design and implementation phase of a semiconductor chip yields a product that meets the yield and performance specifications a large collection of techniques, tools, and design methodologies are at disposal of a chip designer. As a result, the chip designer needs to be able to benchmark all available semiconductor technology node options in order to find the one that best meets the product specification.

With each new generation of semiconductor technology and scaling, relative variability of the performance parameters for semiconductor devices has been increasing. The relative variability is due to an increase in the underlying relative variability of the process technology parameters, such as, electrical and materials parameters. The increase in the relative variability of the switching delay performance parameter in particular, has led to significant issues in determining timing delays along paths which determine the highest operating clock frequencies of a circuit (hereinafter referred to as "critical paths"). Known methods of determining critical path delays in presence of global process technology variation (for example, inter-die) are based on a Static Timing Analysis (STA). The STA is used for estimating worst-case delays along paths within clocked regions of the circuit using logic elements, whose switching delays are characterized for transistor parameter sets representative of a "Slow-Slow" (SS) process corner of the circuit. The transistor parameter at the SS corner represent devices with drive currents (for example, the saturated source-drain current) three standard deviations (3σ) less than the mean value of the measured distribution of drive currents. If all transistors within the critical path possess the same reduction in drive current characteristic of the 3σ point (which is the case for global variability) then STA results in a stable and predictable estimate of worst-case critical path timing. However, STA does not take into consideration increasing variations of delays for transistors due to local variability causes (for example, at least intra-die). The local variability causes a variation in the definition of the SS corner. As a result, the definition of worst-case SS device corner parameter set is unreliable to uniquely define the worst-case performance at the level of the critical path delay.

Efforts to account local variability causes have led to the development of Statistical Static Timing Analysis (SSTA) based algorithms and their associated statistical logic cell characterization methods. The SSTA based methods attempt to account for local variability by not only determining the transistor parameter sets for a nominal SS corner but also transistor parameter sets associated with the intra-die variation in the SS corner drive current. The SSTA based methods, however, consume a lot of time to characterize the timing of logic cells which can be in excess of 1000 logic cells in a standard cell library. For characterization of the variability of a given integrated circuit design in a target semiconductor manufacturing process in a reasonable frame of time, a faster method is needed.

### Summary of the disclosure

It is an aim of the present disclosure to provide a method, system and computer program product for characterizing the variability of a given integrated circuit design in a target semiconductor manufacturing process in fast and computationally efficient way.

These and other aims are achieved according to the disclosure with the subject-matter of the independent claims.

As used herein, with "target semiconductor manufacturing process" or "candidate semiconductor manufacturing process" is intended to mean any known or to be developed semiconductor device manufacturing process, integrated circuit manufacturing process, variants of so-called technology nodes (e.g. as defined in the International Technology Roadmap for Semiconductors) and process corners thereof, of which the process parameters are known from practical experience or simulation.

As used herein, with "standard cell library" is intended to mean a data collection containing definitions and parameters of standard cells and wire-load models for a semiconductor manufacturing process.

As used herein, with "statistically characterized standard cell library" is intended to mean a data collection including statistical distributions of delay values of all possible standard cells and statistical distributions of capacitance values of said all possible standard cells and interconnecting nets, statistically characterized in the target semiconductor manufacturing process to take transistor variability into account.

As used herein, with "path delay statistical distribution" is intended to mean a statistical distribution of the cumulative delay of a data path of an integrated circuit design.

In an aspect, this disclosure provides a method for characterizing the variability of a given integrated circuit design in a target semiconductor manufacturing process. The method comprises the following steps.
a) providing a timing report of said integrated circuit design from an existing description of said integrated circuit design, said existing description resulting from synthesis of said integrated circuit design in said target semiconductor manufacturing process, said timing report containing:
   - semiconductor manufacturing process independent design information comprising a data path structure comprising a sequence of standard cells and nets interconnecting said standard cells, and
   - semiconductor manufacturing process dependent design information comprising delay values of the standard cells in the data path structure and capacitance values of the standard cells and interconnecting nets in the data path structure;
b) creating a functionalized timing trace for at least one data path of said integrated circuit design by using only the semiconductor manufacturing process independent design information of the timing report;
c) determining a path delay statistical distribution for each said functionalized timing trace in said semiconductor manufacturing process, by applying substitute semiconductor manufacturing process dependent design information to said functionalized timing trace, said substitute information comprising:
   - statistical distributions of delay values for the standard cells in the respective data path and
   - statistical distributions of capacitance values for the standard cells and nets in the respective data path;
wherein said statistical distributions of delay values and capacitance values are determined by statistical characterization of the respective standard cells in the target semiconductor manufacturing process to take transistor variability into account and
wherein for nets having a fan-out greater than one an off data path termination load capacitance is considered.

The functionalized timing trace can be seen as the essence of the timing report, which is obtained from an existing description of the integrated circuit design. In particular, the functionalized timing trace contains only the semiconductor manufacturing process independent design information, but functionalized, so that it can take substitute semiconductor manufacturing process dependent design information, such as for example the standard cell library of any target semiconductor manufacturing process or statistically characterized instances thereof, as input. By means of these steps, the impact of transistor variability on a given semiconductor chip or integrated circuit can be quickly assessed, thereby avoiding the need for a re-synthesis and re-timing of the design. In order to enhance the accuracy for the cumulative delay, measures may be taken to distinguish between interconnecting nets having a fan-out greater than one (where there is an off data path termination load capacitance) and the others, so that the difference in capacitance can be taken into consideration.

The speed of the timing analysis using these functionalized timing traces is due to the fact that re-computation of the timing can be limited to only those cells contained in the timing report, preferably only those cells contained in the data path(s) that are considered. So according to the disclosure it is possible to re-calculate the timing for only the statistical distribution of delay values and capacitances for the relevant standard cells in the trace(s) that is/are being considered.

In embodiments according to the present disclosure, a set of statistically characterized standard cell libraries may be provided for the target semiconductor manufacturing process. The set of statistically characterized standard cell libraries include statistical distributions of delay values of all possible standard cells and statistical distributions of capacitance values of said all possible standard cells and interconnecting nets, statistically characterized in the target semiconductor manufacturing process to take transistor variability into account. The substitute information may be taken from said set of statistically characterized standard cell libraries.

In embodiments according to the present disclosure, for each functionalized timing trace, each of said set of statistically characterized standard cell libraries are sequentially applied as input to a processing device configured for evaluating said functionalized timing trace and each time determining a cumulative delay therefrom. The resulting combination of cumulative delays may form said path delay statistical distribution.

In embodiments according to the present disclosure, consideration of the off data path termination load capacitance means that for nets having a fan-out greater than one a greater capacitance value is used than for nets having a fan-out of one.

In embodiments according to the present disclosure, the off data path termination load capacitance for unspecified cells in the timing report may be taken as the sum of an equivalent number of input capacitances of dummy cells, e.g. standard drive-strength inverter cells, defined in said standard cell library for the target semiconductor manufacturing process. This means that the portion of the off data path termination load capacitance due to unspecified standard cell input capacitances in the original timing report may be calculated to be equal to the sum of an equivalent number of input capacitances of the dummy cells.

In embodiments according to the present disclosure, the off data path termination load capacitance for unspecified cells in the timing report may comprise an equivalent multiple of an input capacitance of the standard cell which is subsequent to the considered net, the input capacitance being defined in said standard cell library for the target semiconductor manufacturing process. This means that the portion of the off data path termination load capacitance due to unspecified standard cell input capacitances may be calculated to be equal to an equivalent multiple of an input capacitance of the standard cell which is subsequent to the considered net.

The accuracy may be further improved by performing steps b to c of the above method for characterizing the performance of an integrated circuit design in a target semiconductor manufacturing process for a plurality of data paths, for example, for the N most critical data paths (as regards timing) of the given integrated circuit design. N can be chosen as a trade off between overall calculation time and desired accuracy. In one example N can be at least 100 and/or at most 1000.

In another aspect, this disclosure provides a system for characterizing the variability of a given integrated circuit design in a target semiconductor manufacturing process, the system comprising:
a storage device containing a set of statistically characterized standard cell libraries for the target semiconductor manufacturing process, said set of libraries containing statistical distributions of delay values of all possible standard cells and statistical distributions of capacitance values of said all possible standard cells and interconnecting nets, statistically characterized in the target semiconductor manufacturing process to take transistor variability into account;
an input device, arranged for providing a timing report of said integrated circuit design from an existing description of said integrated circuit design, said existing description resulting from synthesis of said integrated circuit design in said target semiconductor manufacturing process, said timing report containing:
   semiconductor manufacturing process independent design information comprising a data path structure comprising a sequence of standard cells and nets interconnecting said standard cells, and
      - semiconductor manufacturing process dependent design information comprising delay values of the standard cells in the data path structure and capacitance values of the standard cells and interconnecting nets in the data path structure;
a processing system, communicatively connectable to said input device and said storage device and arranged for creating a functionalized timing trace for at least one data path of said integrated circuit design by using only the semiconductor manufacturing process independent design information of the timing report;
said processing system being further arranged for determining a path delay statistical distribution for each said functionalized timing trace in said semiconductor manufacturing process, by applying substitute semiconductor manufacturing process dependent design information, taken from said set of statistically characterized standard cell libraries stored on said storage device, to said functionalized timing trace, said substitute information comprising:
   the statistical distributions of delay values for the relevant standard cells in the respective data path and
   statistical distributions of capacitance values for the relevant standard cells and nets in the respective data path;
   wherein for nets having a fan-out greater than one an off data path termination load capacitance is considered.

Further features and advantages of the system are similar to those of the method described above and will therefore not be elaborated here for reasons of brevity.

In yet another aspect, this disclosure provides a computer program product directly loadable into a memory of a computing device, comprising software code portions for performing the steps of the method described above when executed on said computing device.

### Brief description of the drawings

The disclosure will be further elucidated by means of the following description and the appended figures.
FIG. 1 shows a diagram representing parts of the synthesis of a digital integrated circuit design which pertain to this disclosure.
FIG. 2A-B shows an example of a small section of a typical timing report text file for a 40nm Low Power library according to an embodiment of the present disclosure.
FIG. 3 shows an overview of the conversion of a timing report into a functionalized timing trace using a "trace extraction tool" according to an embodiment of the present disclosure.
FIG. 4 shows the internal modules of the trace extraction tool according to an embodiment of the present disclosure.
FIG. 5 shows the trace function corresponding to the timing report file of FIG. 2 according to an embodiment of the present disclosure.
FIG. 6 illustrates the construction of functionalized timing traces with multiple paths according to an embodiment of the present disclosure.
FIG. 7 shows part of an exemplary 8-bit multiplier circuit design according to an embodiment of the present disclosure.
FIG. 8 shows an exemplary timing report for a critical path of the 8-bit multiplier circuit design according to an embodiment of the present disclosure.
FIG. 9 shows an exemplary trace implementation of the timing report for the critical path of the 8-bit multiplier circuit design according to an embodiment of the present disclosure.
FIG. 10 shows Probability Density Functions (PDF's) for a digital signal processing (DSP) block critical path delay computed using DSP block timing trace for 28nm HPM SS libraries at temperature=0c and Vdd = 0.81 V and Vdd = 0.72V according to an embodiment of the present disclosure.
FIG. 11 shows an overview of the evaluation of a timing trace with statistically characterised standard cell libraries, by means of a "trace evaluation tool", outputting a set of cumulative delays according to an embodiment of the present disclosure.
FIG. 12 shows a block diagram of a statistical logic cell characterization system according to an embodiment of the present disclosure.
FIG. 13 shows a statistical compact model file according to an embodiment of the present disclosure.
FIG. 14 shows a cell netlist according to an embodiment of the present disclosure.
FIG. 15 shows an informative file for model parameters according to an embodiment of the present disclosure.
FIG. 16 shows an informative file for instance parameters according to an embodiment of the present disclosure.
FIG. 17 shows statistical variants of cell netlist and associated statistical device models for the integrated circuit design according to an embodiment of the present disclosure.
FIG. 18 shows characterized cell library files generated by the method/system of the present disclosure according to an embodiment of the present disclosure.

### Detailed description of preferred embodiments

The present disclosure will be described with respect to particular embodiments and with reference to certain drawings but the disclosure is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the disclosure.

Furthermore, the terms first, second, third and the like in the description and in the claims, are used for distinguishing between similar elements and not necessarily for describing a sequential or chronological order. The terms are interchangeable under appropriate circumstances and the embodiments of the disclosure can operate in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the disclosure described herein can operate in other orientations than described or illustrated herein.

Furthermore, the various embodiments, although referred to as "preferred" are to be construed as exemplary manners in which the disclosure may be implemented rather than as limiting the scope of the disclosure.

The term "comprising", used in the claims, should not be interpreted as being restricted to the elements or steps listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising A and B" should not be limited to devices consisting only of components A and B, rather with respect to the present disclosure, the only enumerated components of the device are A and B, and further the claim should be interpreted as including equivalents of those components.

Below, preferred embodiments are described for methods and systems for rapidly assessing a given integrated circuit design in one or a plurality of target semiconductor manufacturing processes. The embodiments can be used to rapidly assess a given design in a target semiconductor manufacturing process or for rapidly comparing performance of a given design in a set of candidate semiconductor manufacturing processes.

### Overview of the synthesis procedure

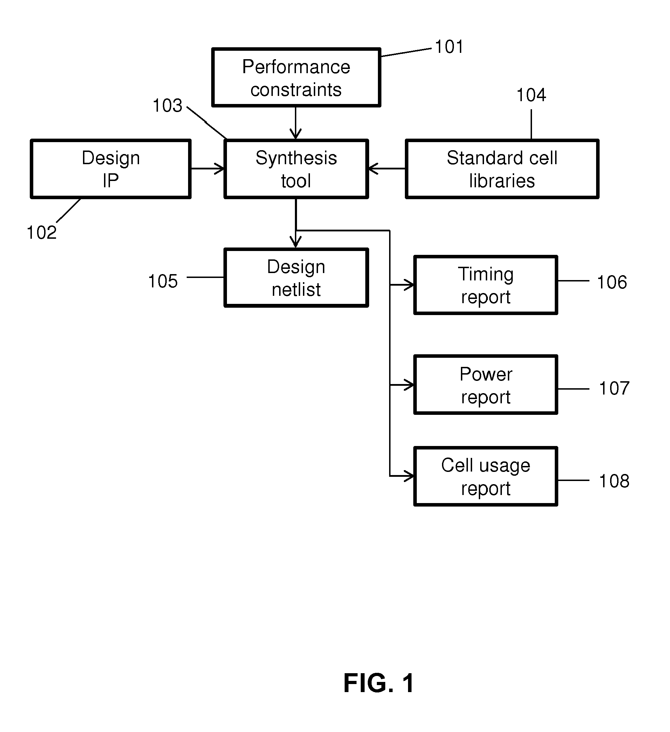

FIG. 1 shows a diagram representing parts of the synthesis of a digital integrated circuit design which pertain to this disclosure. The design IP 102 is represented by potentially multiple data files written hardware description language such as VHDL and is independent of the process technology used for its final implementation in silicon. The standard logic cell libraries 104 represent data files which may contain timing, power and area information for the logic cells implemented in a specific technology node, node option and process corner (such as the 40nm technology node with a low power, high threshold voltage option and operating a worst case process corner) used for the implementation of the design in silicon.

The synthesis tool 103 implements the design IP 102 in the technology defined by the standard cell libraries 104 by selecting logic cells from the library in order to meet design performance constraints 101 such as clock rate, power and area. The result is the implementation of the design in the form of a technology-dependent netlist 105 which contains the selected cells and the connections (nets) between them. The synthesis tool 103 may also be instructed to provide timing, area and power reports 106-108 which may be used to ensure that the required performance constraints 101 have been met for the specific technology options and process corners defined by the standard cell libraries 104 used in the synthesis procedure.

The timing report 106 includes semiconductor manufacturing process independent design information and semiconductor manufacturing process dependent design information. The semiconductor manufacturing process independent design information may include a data path structure comprising a sequence of standard cells and nets interconnecting said standard cells, pin names, cell names, fan-outs and the like, of the design. The semiconductor manufacturing process dependent design information may include specific numeric technology information such as delay values of the standard cells in the data path structure located in the slowest paths of the design which are computed for cells characterized for a specific technology choice at for example a slow-slow corner, capacitance values of the standard cells and interconnecting nets in the data path structure, transition time, and the like. Examples of specific technology choices include, but are not limited to, a low power or high performance technology, or a change in the threshold voltage or supply voltage of the devices. The timing reports can thus indicate whether target clock rates for a given design are satisfied at different stages of design flow.

### The timing trace extraction algorithm

An aspect of this disclosure is a method to transform the timing reports generated as a part of the synthesis from passive, technology-dependent text files into active, technology independent functions, which are referred to as functionalized timing traces. These functionalized timing traces are active in the sense that they can take standard cell libraries as input arguments and can take information thereform to recalculate the timing for the trace. It has been found that the calculations may be extremely fast and can be used to evaluate different technology selections in seconds.

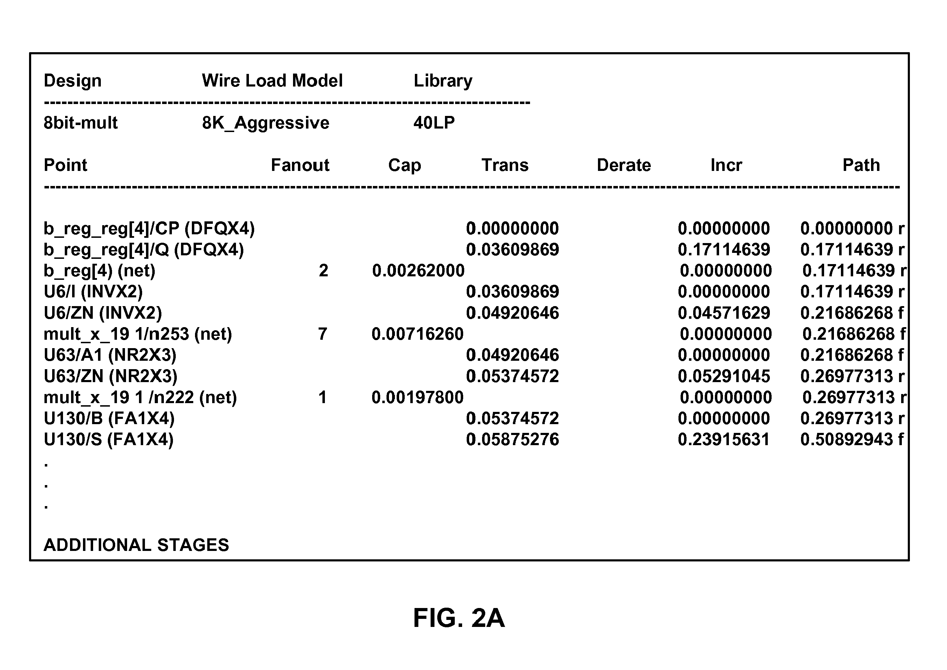

We shall first consider the creation of a timing trace as it is called herein. The timing report 106 contains a mixture of design information such as pin names, cell names, fan-outs as well as specific numeric technology information in the form of capacitance, transition time, and delay values. An example of a small section of a typical timing report 106 text file for a 40nm Low Power library is shown in FIG. 2A-B. It indicates that the slowest data path through the circuit (which defines the clock rate of the design) starts with a step input signal (a transition time of zero) at the clock pin (CP) of a D flip-flop (DFQX4). The signal then appears at the output pin of the D flip-flop (Q) with a rise time of 0.036 ns and travels along a net with a fan-out of two and a total capacitance of 0.026 pF and arrives at the input pin (I) an inverter (INVX2) after a delay of 0.17 ns. The signal continues through the inverter to a NOR cell (NR2D4) via one of the seven branches of a net to a Full Adder (FA1X4) and on subsequent cells in the critical timing path of the design until the path is ultimately terminated by another clocked D flip-flop (DFQX2). The setup time for this terminating flip is calculated and this finishes the timing report 106.

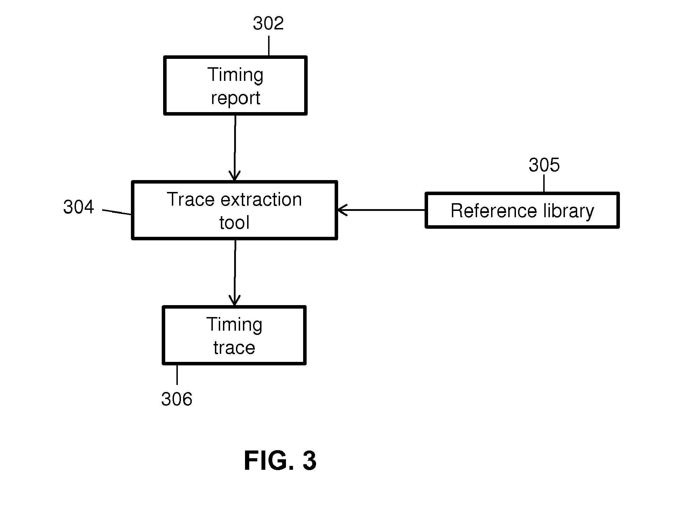

FIG. 3 shows an overview of the conversion of a timing report 302 into a functionalized timing trace 306 using a "trace extraction tool" 304. The tool 304 reads in the timing report 302 text file and the library 305 used to create the report (the reference library 305) is imported into the tool. In embodiments of this disclosure, this library format, which may be an industry standard format, is exploited to provide statistically varied instances of such libraries, in which the information of relevant cells is statistically varied, to the functionalized timing trace, to quickly obtain an idea of the impact of variability on the timing.

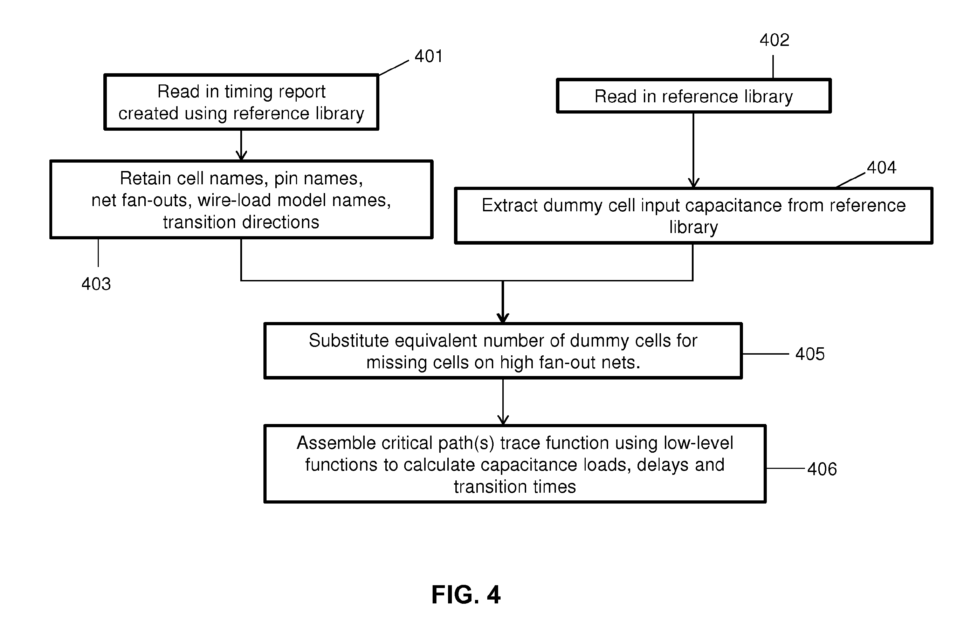

FIG. 4 shows the internal modules of the trace extraction tool. Modules 401 and 402 perform the read-in of the timing report and reference library, respectively. Module 403 parses through the timing report information and retains information relating to wire-load models, cell names, pin names, net fan-outs and signal transition directions (rising or falling) are stored. In addition, Module 403 also retains load capacitance values for use in the Module 405 for estimating the missing information in the timing report on the input capacitances of cells terminating high fan-out nets.

Modules 402, 404, and 405 may be used to enhance accuracy. The timing report only specifies cell names which lie directly on the data path. This is not a problem when cells are connected point-to-point by nets with no branches (that is, which have a fan-out of one). When nets have a fan-out greater than one, branches of the direct net split off from the timing path and are terminated by unspecified cell input capacitances. This is not a problem for the timing report as only the total load capacitance is required for timing analysis.

The functionalized timing trace implements an active timing report by means of which the total load capacitance for each stage in the timing path can be calculated on the basis of the files in the library. Since the library contains wire-load models, the net capacitance for a given fan-out can be calculated. The total load capacitance is the sum of the net capacitance and the input capacitances of the unspecified terminating cells.

Module 405 computes the termination capacitance for cells located on off-path net branches by first calculating the net capacitance from the wire-load model specified in the timing report as a function of its fan-out. This net capacitance and the known capacitance of the cell lying in the timing path are then subtracted from the total capacitance in the timing report to leave the total missing cell termination capacitance. Module 405 then converts this missing termination capacitance into the capacitance associated with an equivalent number of dummy drive-strength 1 inverters from the reference library, using information provided by Module 404. In this way, the numerical value of the total off timing path termination capacitance is converted into an equivalent number of inverter input capacitances which can be re-calculated for each new library given as an input argument to the trace.

Module 405 implements one way to take into consideration that there is an off data path termination load capacitance at the nets having a fan-out greater than one. Other examples are to use a predetermined, greater capacitance value for such nets than for nets having a fan-out of one, or to use an equivalent multiple (i.e. the multiple being chosen in function of the fan-out) of the input capacitance of the standard cell which is immediately subsequent to the considered net.

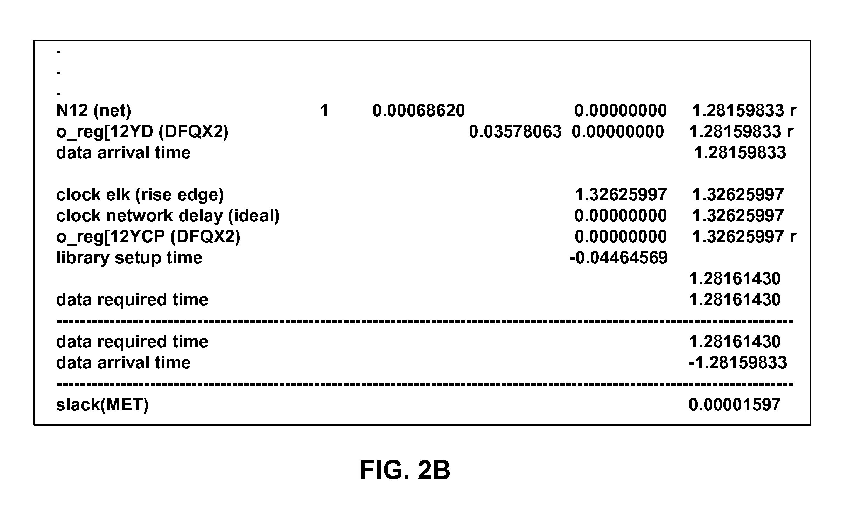

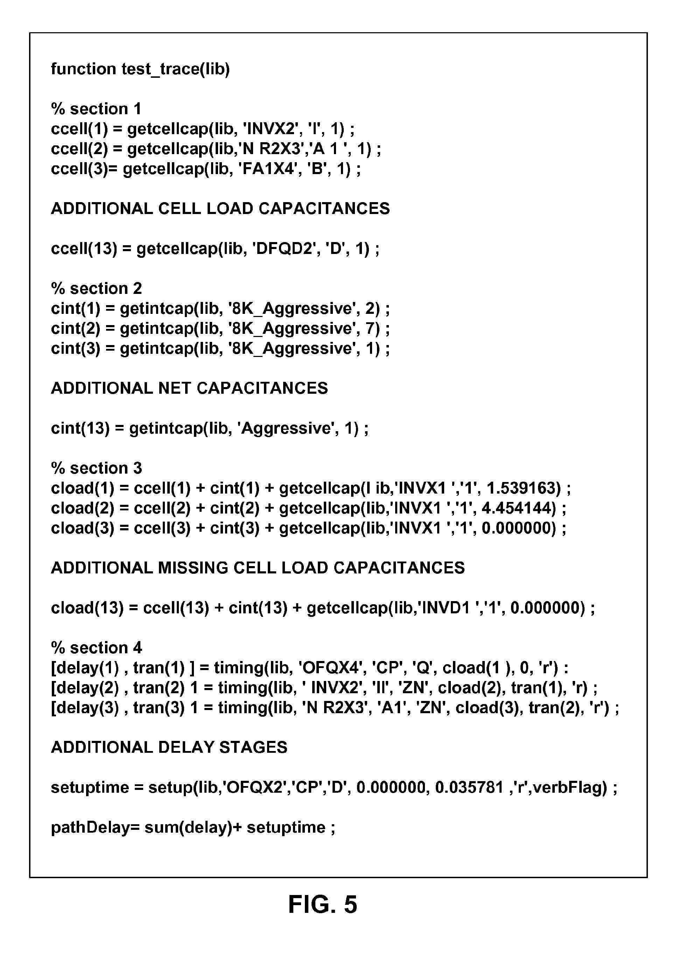

Finally, Module 406 reconstructs the timing path and inserts low level functions to re-calculate load capacitances and timing data for each stage. The result of this process is shown in FIG. 5, which shows the trace function corresponding to the timing report file of FIG. 2. We first notice that the function accepts an input argument which is a standard cell library 'lib'. This could the library of any technology option that we are interested in evaluating. The next stage recalculates the input capacitances of the cells in the timing path using the low-level function 'getcellcap'. This function takes the library and cell names as input arguments, as well as the name of the input pin. The last argument represents a multiplication factor which is not utilized in this section and is set to one.

The second section uses the low-level function 'getintcap' to recalculate net capacitances from the wire-load model contained in the library as a function of the fan-out of the net. We observe that the first three nets specified in this section have fan-outs of 2, 7 and 1, respectively. The third section re-calculates the total load from three components: the known cell loads, the net loads and the capacitances of the equivalent number of dummy inverters calculated by the trace extraction tool. The off path terminating capacitances are calculated using the same 'getcellcap' function from the first section, but this time using the multiplier argument. We observe that the off path terminating capacitance of the first net with fan-out 2 is equivalent to 1.52 IVNX1 input capacitances, while the off-path terminating capacitances of the second net with fan-out 7 are equivalent to 4.45 INVX1 input capacitances. The third net is a direct point-to-point net with no branches (fan-out one) and so the multiplier is set to zero as no additional terminating cells are present.

Section 4 re-assembles the critical path using the data calculated in section 1 through 3 using another low-level function called 'timing'. This function emulates the static timing analysis routines in the synthesis tool and takes the library and cell names as input arguments. The 'timing' also takes the input pin name, the output pin name, the load capacitance and the signal transition time on the input pin. The output of the 'timing' function is the delay through the cell stage and the output transition time. We note that the input transition time of the first cell (DFQX4) is a step input (transition time zero) and that the output transition time is used as the input transition time to the next cell in the path. The end of section 4 sums all the stage delays and adds the setup time of the terminating flip-flop in order to calculate the total delay through the timing path.

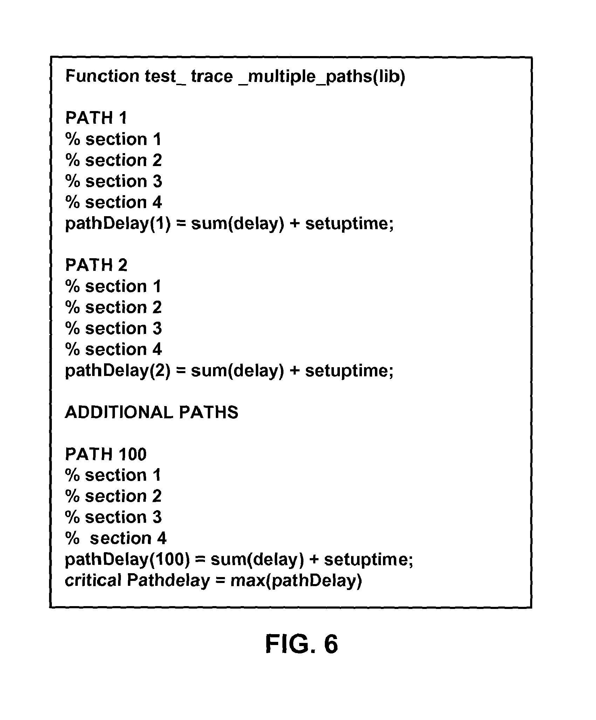

The timing report 106 is not restricted to displaying the slowest timing path in the design. The synthesis tool can be instructed to write out the N slowest paths in the design, N being for example 100 or more up to 1000. Normally, this is not done as it is only the slowest path (termed the critical path) that determines the clock rate of the design. However, when a functionalized timing trace is used with a different (target) library than the (reference) library used in its construction, it is possible that the slowest path is different from the slowest path in the reference technology. Therefore, in preferred embodiments, traces are constructed from the N slowest paths obtained from the reference library timing report. The delays through all N paths are computed and the maximum delay selected as the critical path delay. The choice of N is a trade-off between calculation speed and delay path coverage. We have found the N=100 produces satisfactory coverage and calculation times measured in seconds. The construction of functionalized timing traces with multiple paths is illustrated in FIG. 6.

### The timing trace evaluation algorithm

The standard cell libraries 104 which are known in the art may represent data files which may contain timing, power and area information for the logic cells implemented in a specific technology node, node option and process corner used for the implementation of the design in silicon. In embodiments of this disclosure, the same format of standard cell library is used to provide a set of statistically characterized standard cell libraries. This set of statistically characterized standard cell libraries includes statistical distributions of delay values and capacitance values of standard cells determined by statistical characterization of the respective standard cells in the target semiconductor manufacturing process to take transistor variability into account. This set of statistically characterized standard cell libraries is an embodiment, according to this disclosure, to provide the substitute semiconductor process dependent information.

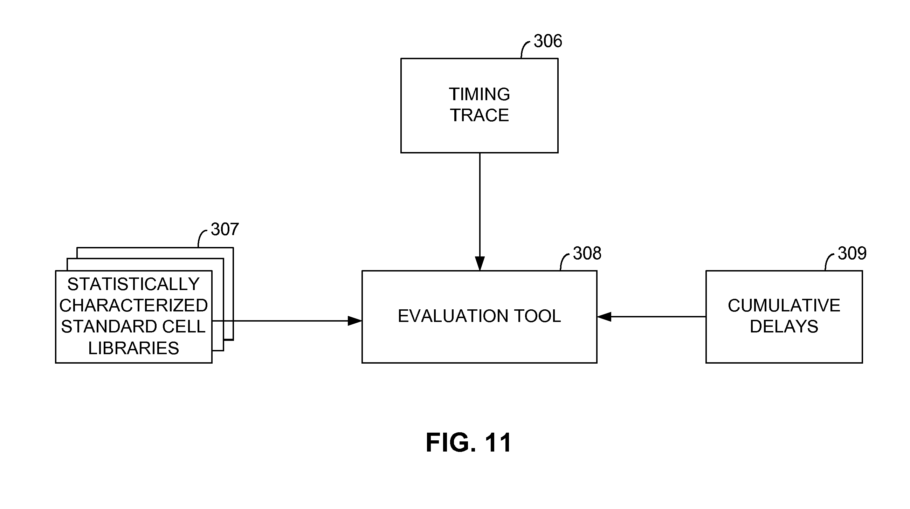

In embodiments of this disclosure, this is done as follows and as shown in FIG. 11: for each functionalized timing trace 306, sequentially applying each of said set of statistically characterized standard cell libraries 307 as input to a processing device or evaluation tool 308 configured for evaluating said functionalized timing trace and each time determining a cumulative delay 309 therefrom. The resulting combination of cumulative delays forms an embodiment of the path delay statistical distribution as defined herein.

The processing device 308 can thus determine a path delay statistical distribution for each said functionalized timing trace in a target semiconductor manufacturing process, by applying substitute semiconductor manufacturing process dependent design information to said functionalized timing trace. The substitute semiconductor manufacturing process dependent design information may include statistical distributions of delay values for the standard cells in the respective data path, and statistical distributions of capacitance values for the standard cells and nets in the respective data path. The statistical distributions of the delay values and the capacitance values may be determined by statistical characterization of the respective standard cells in the target semiconductor manufacturing process to take transistor variability into account. For nets having a fan-out greater than one an off data path termination load capacitance is considered, as this has been embedded in the functionalized timing trace 306.

In embodiments of this disclosure, the set of statistically characterized standard cell libraries 307 may include statistical distributions of delay values of all possible standard cells and statistical distributions of capacitance values of said all possible standard cells and interconnecting nets, statistically characterized in the target semiconductor manufacturing process to take transistor variability into account. In alternative embodiments, the substitute information may also be provided in other ways, such as for example by providing only substitute information for the standard cells in the data paths that are determined to be relevant to recalculate the timing of the design. In such embodiments, the substitute information may contain only statistical distributions of delay values for the standard cells in the respective data path and statistical distributions of capacitance values for the standard cells and nets in the respective data path. A way of implementing such an embodiment which nonetheless makes use of an industry standard library format is described further herein.

### Further example

For further clarification, another detailed example is given below, referring to figs 3, 4 and 7-10.

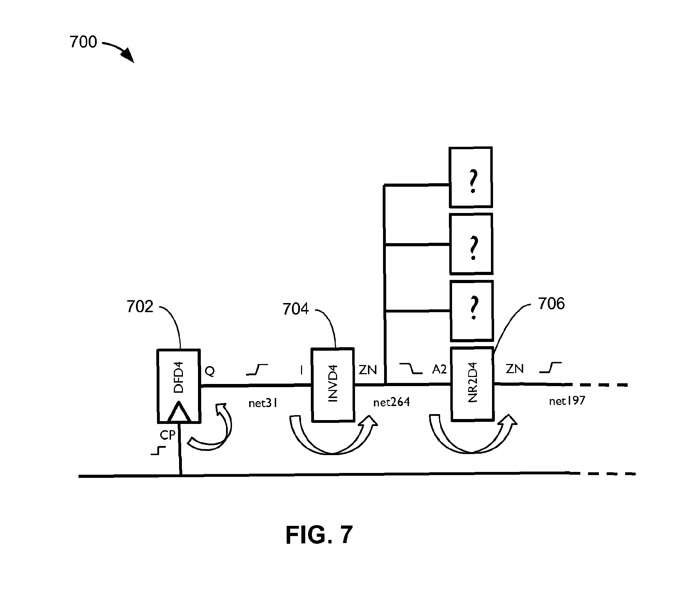

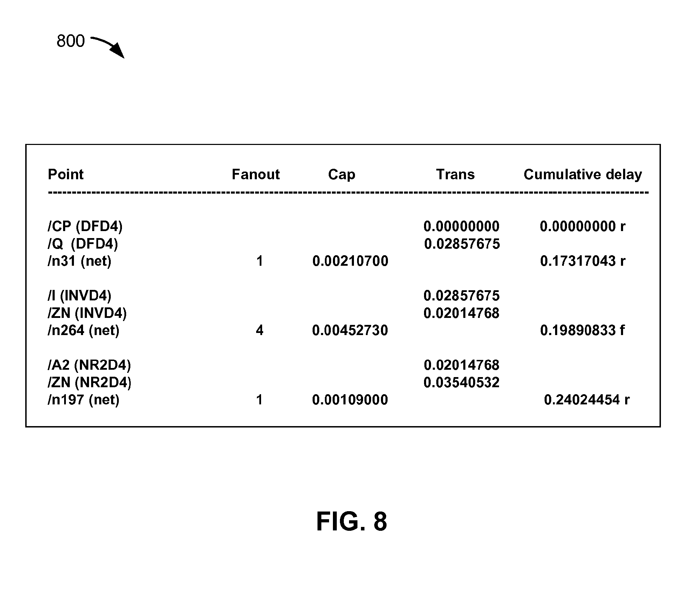

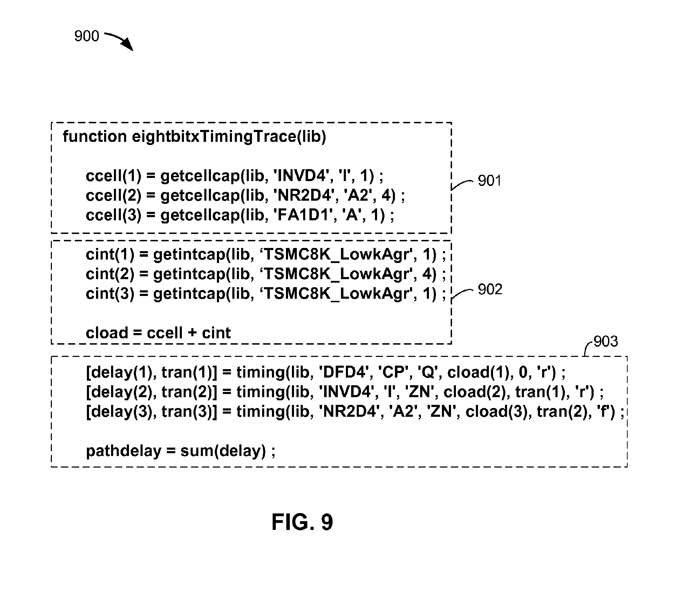

FIG. 7 schematically shows part of an exemplary 8-bit multiplier circuit design 700. In one example implementation, a critical path of the 8-bit multiplier circuit 700 may be identified to be a path formed by components a D flip-flop (DFD4) 702, an inverter (INVD4) 704, and a NOR (NR2D4) 706. A relevant part of a timing report 800 for the critical path is shown in FIG. 8. The timing report 800 indicates the slowest data path through the circuit (which defines the clock rate of the design) starting with a step input signal (a transition time of zero) at the clock pin (CP) of the DFD4 702. The signal then appears at the output pin (Q) of the D flip-flop with a rise time of 0.0285 ns and travels along a net with a fan-out of one and a total capacitance of 0.0021 pF and arrives at the input pin (I) of the INVD4 704 after a delay of 0.17 ns. Further, the signal passes through the input pin (I) with a rise time of 0.285 ns and travels along a net with a fan-out of four and a total capacitance of 0.0045 pF and arrives at output pin (ZN). The signal arrives at an input pin (A2) of clocked NR2D4 706 after a delay of 0.19 ns. The trace implementation of the timing report 800 shown in FIG. 8 is shown in FIG. 9. The timing trace is written in functional form and can take a standard cell library as an input argument, indicated by the variable 'lib' in first line.

So FIG. 9 shows an exemplary trace implementation 900 of the timing report 800 for the critical path of the 8-bit multiplier circuit design described above. FIG. 9 illustrates a section 901 that the trace receives an input argument which is a standard cell library 'lib'. This may be a library of any technology option that can be evaluated. The recalculation of the input capacitances of the cells is shown in timing path using a low-level function 'getcellcap'. The getcellcap function may takes the library and cell names as input arguments, as well as the name of the input pin. The last argument represents a multiplication factor which is not utilized in this section and is set to one.

Section 902 uses the low-level function 'getintcap' to recalculate net capacitances from using the wire-load model contained in the standard library cells contained in the library as a function of the fan-out of the net. As described above, the first three nets specified have fan-outs of 1, 4 and 1, respectively. The computation is performed using statistical distributions of delay values for the standard cells in the respective data path, and statistical distributions of capacitance values for the standard cells and nets in the corresponding data path.

Section 903 re-assembles the critical path using the data calculated in section 1 through 2 using another low-level function called 'timing'. This function emulates the statistical static timing analysis routines in the synthesizer unit and takes the statistical standard cell library as input arguments. For each timing trace, a corresponding set of statistically characterized standard cell libraries are sequentially applying as input to determine a cumulative delay. The resulting combination of cumulative delays is obtained which forms the path delay statistical distribution.

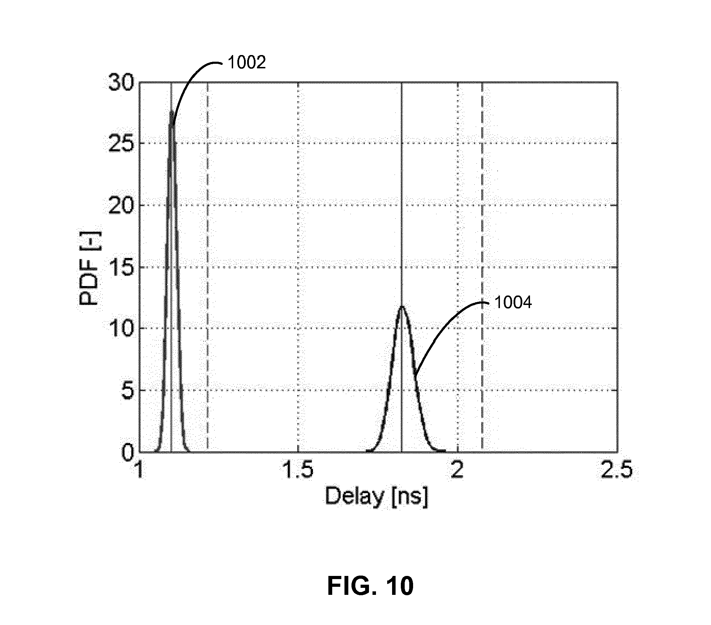

The technique for SSTA proposed in this example uses multiple statistical instances of standard cell libraries generated by a commercial library characterization tool as input arguments for a timing trace. To obtain a valid statistical sample of the corresponding distribution of critical path delays, the number of statistical instances of a library may be around 50 or greater. While such number of statistical instances would represent a huge computational task if each cell in the library had to be re-characterized 50 times for global and local variability. The fact that the trace only uses limited cells to perform statistically timing characterization by limiting them to only those cells contained in the delays paths in the timing trace makes the approach feasible. FIG. 10 shows the distribution of critical path delays, expressed as probability density functions, generated by the digital signal processing timing trace from 50 statistical instances of a 28nm HPM SS library characterized at a temperature of 0V and supply voltages of Vdd=0.81 V (curve 1002) and Vdd=0.72V (curve 1004), for the above-described multiplier circuit.

The advantage is that very few cells need to be statistically characterized to assess critical path variability. This can result in significant speed-up of computation.

### Statistically characterized standard cell libraries

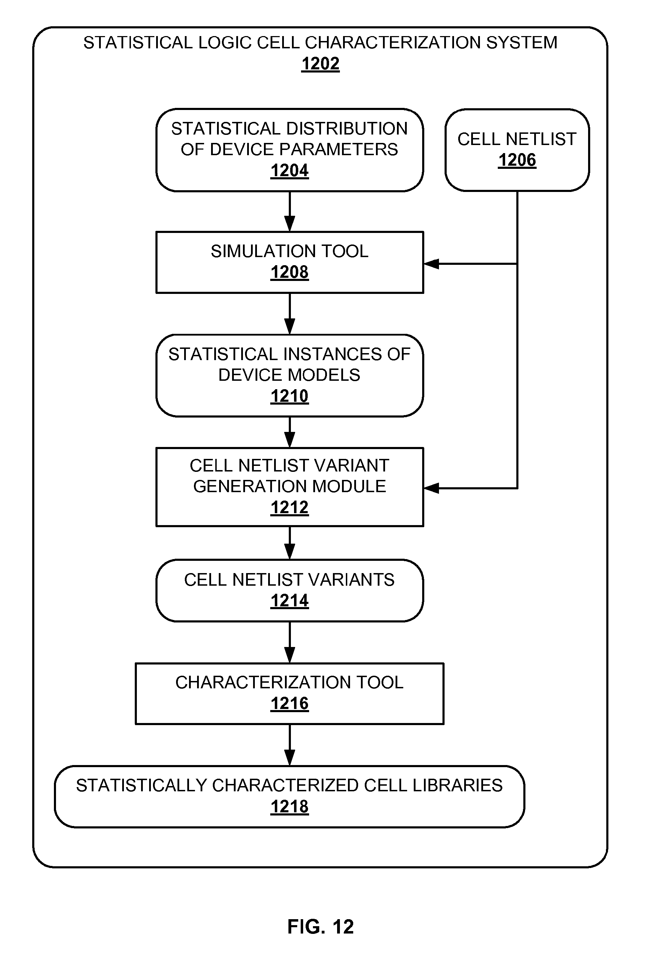

In the following, an embodiment of providing statistically characterized standard cell libraries in an industry standard (e.g. .lib) format is described, with reference to FIGS. 12-18.

Referring to FIG. 12, a statistical logic cell characterization system 1202 (hereinafter, 'system 1202') is disclosed.

The system 1202 includes a simulation tool 1208 which generates statistical instances of device models 1210 using statistical distribution of device parameters 1204. The statistical distribution of device parameters 1204 is usually obtained from a physical design kit. The physical design kit (PDK) is generated and supplied by semiconductor device manufacturers or better known as foundries. The PDK may have variations based on a particular foundry which had generated the PDK. The PDK includes statistical compact models of semiconductor devices, for example, N-type transistors, P-type transistors, diodes and the like. The semiconductor device models supplied by the foundry may include pre-defined device models for defined process corners, for example, slow, fast, typical, maximum leakage and the like, and internal statistical distributions of device parameter sets.

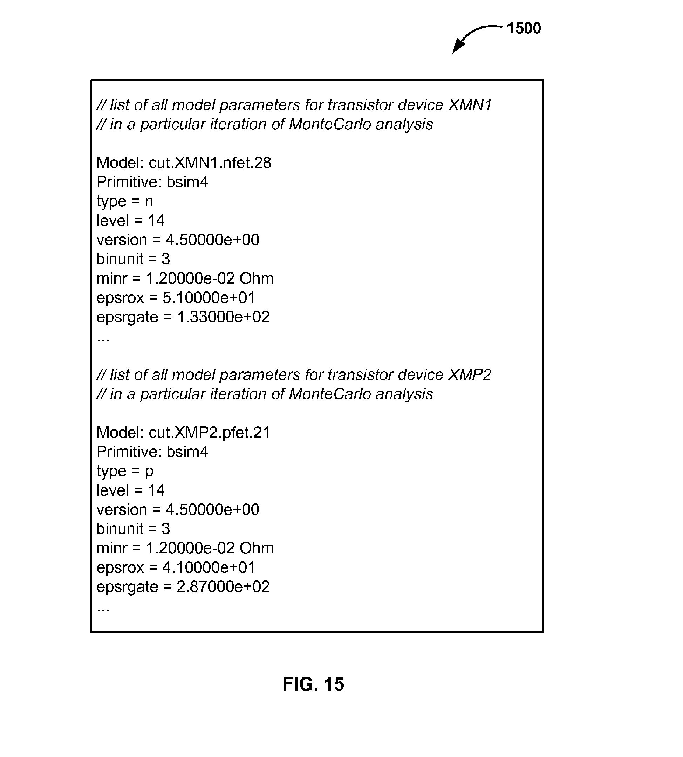

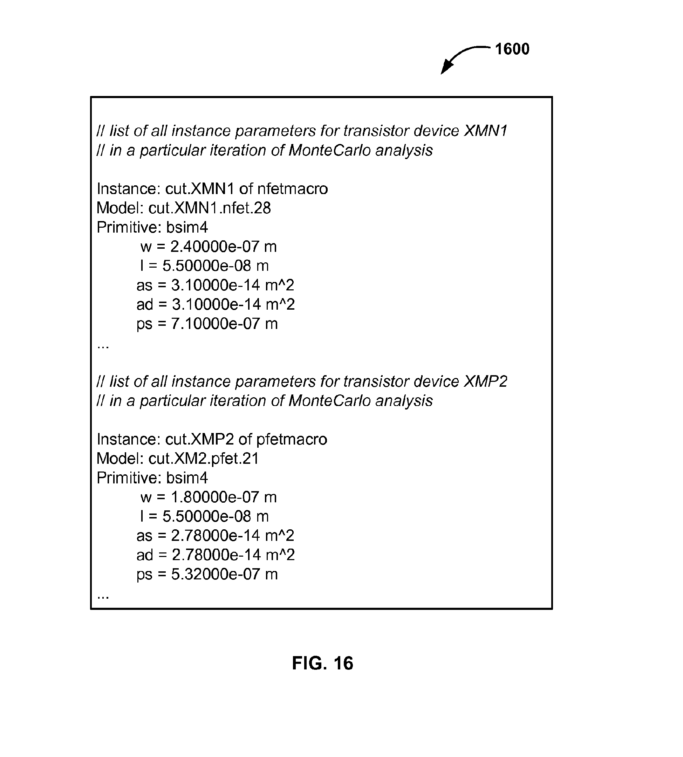

The simulation tool 1208 is run, for example, in a Monte Carlo analysis mode to generate statistical device models 1210. The generated statistical device models 1210 are stored as a report file containing instance parameters of the devices and a report file containing model parameters of the devices. The simulation tool 1208 reads statistical distribution of device parameters 1204 and outputs statistical device models 1210 while running in a loop without actually perform any circuit simulation. An example of the output report file containing instance parameters of the devices is illustrated in FIG. 16 and an example of the output report file containing model parameters of the devices are device model files is illustrated in FIG. 15. In one embodiment of the present disclosure, the simulation tool 1208 may be a part of an existing general purpose circuit simulator, such as, SPECTRE by CADENCE. In a different embodiment, when the statistical distributions of device parameters 1208 are stored in human readable format, it is possible to perform a direct evaluation of stored parameter relations and functions.

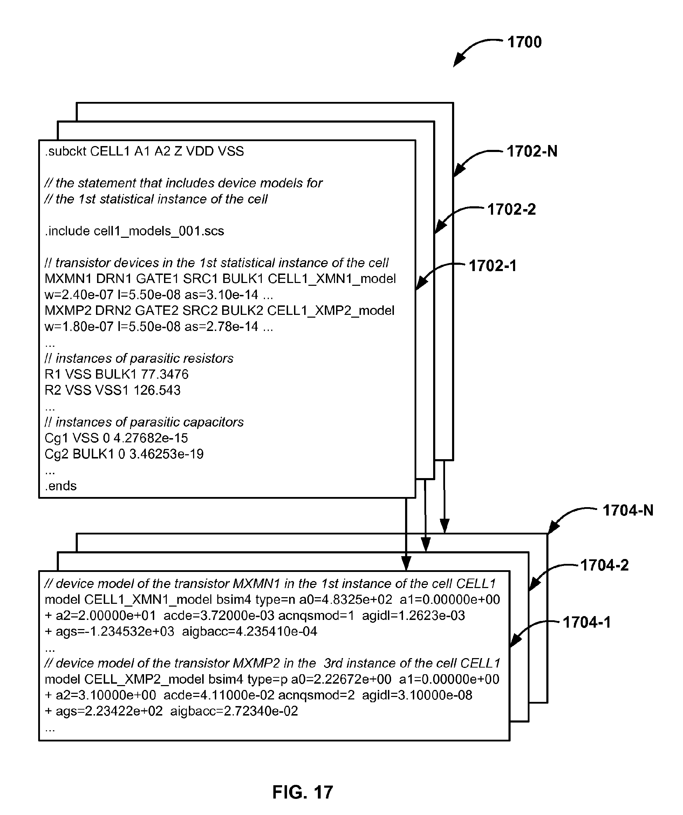

The system 1202 further includes a cell netlist variant generation module 1212 which generates cell netlist variants 1214 using the statistical device models 1210 and a cell netlist 1206. The cell netlist variant generation module 1212 creates N instances of the cell netlist and connects each cell netlist instance with the corresponding cell model file, thereby generating N variants of the cell netlist 1206. The cell model files are generated using the statistical device models 1210. One example of the N variants of the cell netlist 1206 is illustrated in FIG. 17, where N instances of the cell netlist 1702-1 through 1702-N are linked to respective cell model instances 1704-1 through 1704-N. In one embodiment, the cell netlist variant generation module 1212 may be a part of the characterization tool 1216. In another embodiment, the cell netlist variant generation module 1212 may be a part of the simulation tool 1208.

The system 1202 includes a characterization tool 1216 for characterizing the cell netlist variants 1214 thereby generating statistically characterized cell libraries 1218. One example of such a library characterization tool is ALTOS LIBERATE by CADENCE. In one embodiment, the characterization tool 1216 is a non-statistical characterization tool. The characterization tool 1216 is used to perform cell characterization using multiple statistical instances of the cell netlist rather than using a single cell netlist with multiple statistical instances of the device model. Each statistical instance of the cell netlist includes devices with unique parameter sets thus generating cell netlist variants 1214. Thus, distributions of timing values are obtained by performing multiple characterization runs of the statistical cell instances using a standard non-statistical cell characterization tool.

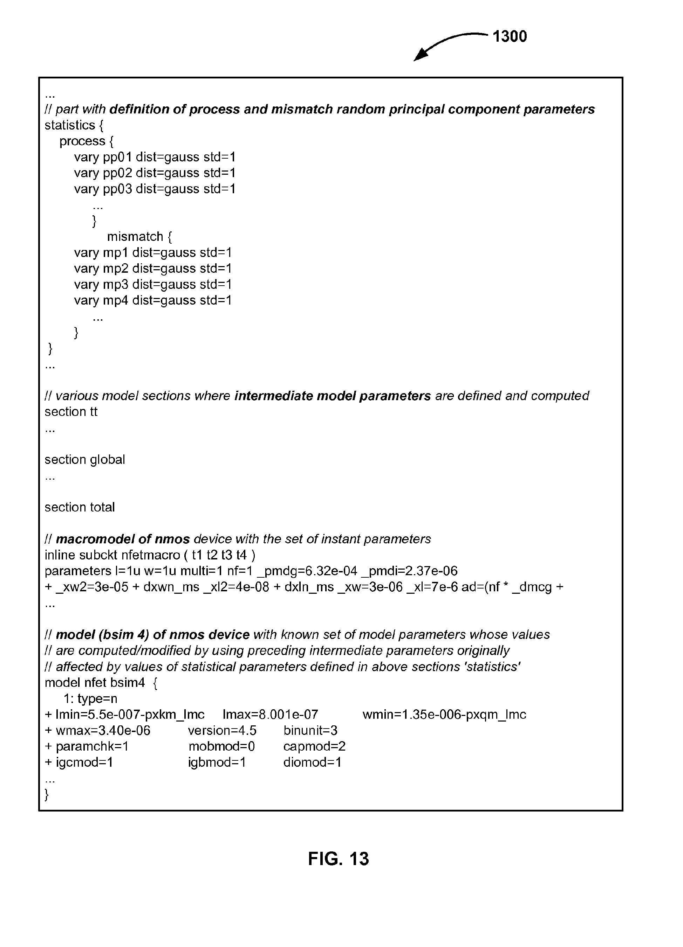

FIG. 13 shows a statistical compact model file 1300 according to one embodiment of the present disclosure. The model file 1300 is created and supplied by the semiconductor device manufacturers. The model file 1300 includes definition of process and mismatch random principal component parameters and their statistics. The model file 1300 further includes definition and instructions for computing intermediate model parameters. The model file 1300 is used to generate statistical instances of a device model. One statistical instance of the model is included in a variant of the cell netlist. A person skilled in the art will appreciate that in FIG. 13 only part of the information actually present in the model file 1300 is shown, for the purpose of explaining the present disclosure.

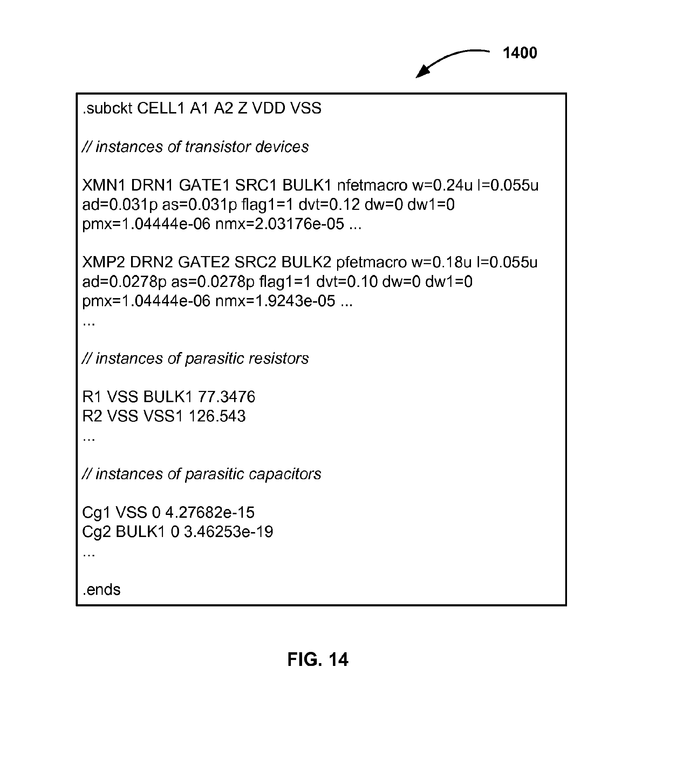

FIG. 14 shows a cell netlist 1400 in accordance to one embodiment of the present disclosure. The cell netlist 1400 represents netlist after place and route stage of the integrated circuit design process. The cell netlist 1400 includes description of device instances and extracted parasitic resistors and capacitors. A person skilled in the art will appreciate that in FIG. 14 only part of the information actually present in a cell netlist 1400 is shown, for the purpose of explaining the present disclosure.

FIG. 15 shows a file 1500 having lists of model parameters of devices in the cell to be characterized. For example, the file shows model parameters for a transistor device XMN1. The model parameters include, but are not limited to, MINR, EPSROX, and EPSRGATE. MINR is minimum source/drain resistance. EPSROX and EPSRGATE represent dielectric constant of the gate oxide and gate relative to vacuum, respectively for the transistor device XMN1. Similarly, model parameters are defined for a second transistor device XMP2 described in the file. A person skilled in the art will appreciate that there are many other model parameters which may be used in practice and that only a small portion of actual file is shown, sufficient for the purpose of explaining the present disclosure. Further, a person skilled in the art will appreciate that there may be many devices in a cell netlist and only two devices are shown here for illustration purposes.

FIG. 16 shows a file 1600 having lists of instance parameters of devices in the cell to be characterized. For example, the file 1600 shows instance parameters and their values for a given statistical instance for a transistor device XMN1 corresponding to model parameters of FIG. 14. The instance parameters include but not limited to W, L, AS, AD, and PS. W is a default channel width of the transistor device XMN1. L is a default channel length of the transistor device XMN1. AS is an area of source diffusion and AD is an area of drain diffusion. PS is a perimeter of source diffusion. Similarly, values for the instance parameters at a given statistical instance are output for a second transistor device XMP2 described in the file. A person skilled in the art will appreciate that there are many other instance parameters which may be used in practice and that only a small portion of the actual file is shown, sufficient for the purpose of explaining the present disclosure.

FIG. 17 shows files 1700 of N statistical variants of the cell netlist 1702-1 through 1702-N and N statistical device models 1704-1 to 1704-N for the integrated circuit design according to an embodiment of the present disclosure. As shown, each instance of the cell netlist is associated with a corresponding instance of the model file, for example, the cell netlist variant 1702-1 is associated with the model file instance 1704-1, and so on. The cell netlist variants 1702-1 through 1702-N are generated by combining a statistical device model instance with an instance of the cell netlist.

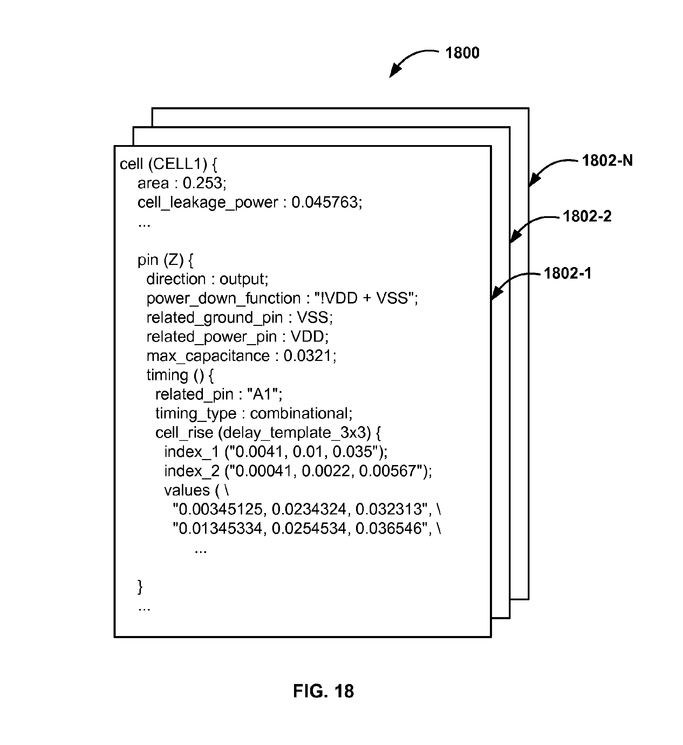

FIG. 18 shows, in an exemplary embodiment of the present disclosure, statistically characterized standard library files 1800. The library files 1800 include a statistical set of N standard cell libraries. The statistical set includes cell libraries 1802-1 through 1802-N. Each cell library of the set includes instances of all characterized standard cells. The cell library may be in any suitable format, proprietary or open standard, known in the art. In one embodiment, the cell library is in (.lib) liberty file format. Cell library 1802-1 includes, but not limited to, timing and power characteristics of a first instance of the standard cell. Similarly, other cell libraries include timing and power characteristics when input model and/or instance parameters are statistically varied for the same standard cell. Therefore, output 1800 represents statistical distribution of timing and power data for each cell of the set of relevant standard cells which have been characterized. The statistical distribution of timing and power data takes into account local or global variability within a cell.

## Claims

1. A method for characterizing the variability of a given integrated circuit design in a target semiconductor manufacturing process, the method comprising:
a) providing a timing report (106, 302) of said integrated circuit design from an existing description of said integrated circuit design, said existing description resulting from synthesis of said integrated circuit design in said target semiconductor manufacturing process, said timing report (106, 302) containing:
- semiconductor manufacturing process independent design information comprising a data path structure comprising a sequence of standard cells and nets interconnecting said standard cells, and
- semiconductor manufacturing process dependent design information comprising delay values of the standard cells in the data path structure and capacitance values of the standard cells and interconnecting nets in the data path structure;
b) creating a functionalized timing trace (306) for at least one data path of said integrated circuit design by using only the semiconductor manufacturing process independent design information of the timing report;
c) determining a path delay statistical distribution for each said functionalized timing trace (306) in said semiconductor manufacturing process, by applying substitute semiconductor manufacturing process dependent design information (307) to said functionalized timing trace (306), said substitute information comprising:
- statistical distributions of delay values for the standard cells in the respective data path and
- statistical distributions of capacitance values for the standard cells and nets in the respective data path;
wherein said statistical distributions of delay values and capacitance values are determined by statistical characterization of the respective standard cells in the target semiconductor manufacturing process to take transistor variability into account and
wherein for nets having a fan-out greater than one an off data path termination load capacitance is considered.

2. The method of claim 1, wherein the method further comprises the step of providing a set of statistically characterized standard cell libraries (307) for the target semiconductor manufacturing process, said set of libraries containing statistical distributions of delay values of all possible standard cells and statistical distributions of capacitance values of said all possible standard cells and interconnecting nets, statistically **characterized in** the target semiconductor manufacturing process to take transistor variability into account; and wherein said substitute information is taken from said set of statistically characterized standard cell libraries (307).

3. The method of claim 2, wherein step c comprises, for each functionalized timing trace (306), sequentially applying each of said set of statistically characterized standard cell libraries (307) as input to a processing device (308) configured for evaluating said functionalized timing trace (306) and each time determining a cumulative delay therefrom; and wherein the resulting combination of cumulative delays (309) forms said path delay statistical distribution.

4. The method of any one of the preceding claims, wherein the considering of the off data path termination load capacitance means that for nets having a fan-out greater than one a greater capacitance value is used than for nets having a fan-out of one.

5. The method of any one of the preceding claims, wherein the off data path termination load capacitance comprises, for unspecified cells in the timing report, the sum of an equivalent number of input capacitances of dummy cells, defined in a standard cell library (104) for the target semiconductor manufacturing process.

6. The method of claim 5, wherein the dummy cells are standard drive-strength inverter cells.

7. The method of any one of the claims 1-4, wherein the off data path termination load capacitance comprises, for unspecified cells in the timing report, an equivalent multiple of an input capacitance of the standard cell which is subsequent to the considered net, the input capacitance being defined in a standard cell library (104) for the target semiconductor manufacturing process.

8. The method of any one of the preceding claims, wherein steps b and c are performed for a plurality of data paths of said integrated circuit design.

9. The method of claim 8, wherein said plurality of data paths comprises the N most critical data paths of said integrated circuit design.

10. The method of claim 9, wherein N is at least 100.

11. A system for characterizing the variability of a given integrated circuit design in a target semiconductor manufacturing process, the system comprising:
a storage device containing a set of statistically characterized standard cell libraries (307) for the target semiconductor manufacturing process, said set of statistically characterized standard cell libraries (307) containing statistical distributions of delay values of all possible standard cells and statistical distributions of capacitance values of said all possible standard cells and interconnecting nets, statistically **characterized in** the target semiconductor manufacturing process to take transistor variability into account;
an input device, arranged for providing a timing report (106) of said integrated circuit design from an existing description of said integrated circuit design, said existing description resulting from synthesis of said integrated circuit design in said target semiconductor manufacturing process, said timing report containing:
- semiconductor manufacturing process independent design information comprising a data path structure comprising a sequence of standard cells and nets interconnecting said standard cells, and
- semiconductor manufacturing process dependent design information comprising delay values of the standard cells in the data path structure and capacitance values of the standard cells and interconnecting nets in the data path structure;
a processing system (304 and 308), communicatively connectable to said input device and said storage device and arranged for creating a functionalized timing trace (306) for at least one data path of said integrated circuit design by using only the semiconductor manufacturing process independent design information of the timing report;
said processing system being further arranged for determining a path delay statistical distribution for each said functionalized timing trace in said semiconductor manufacturing process, by applying substitute semiconductor manufacturing process dependent design information, taken from said set of statistically characterized standard cell libraries stored on said storage device, to said functionalized timing trace, said substitute information comprising:
- the statistical distributions of delay values for the relevant standard cells in the respective data path and
- statistical distributions of capacitance values for the relevant standard cells and nets in the respective data path;
wherein for nets having a fan-out greater than one an off data path termination load capacitance is considered.

12. The system of claim 11, wherein said processing system (304 and 308) is arranged for sequentially applying, to each functionalized timing trace (306), each of said set of statistically characterized standard cell libraries (307), and each time determining a cumulative delay therefrom; and wherein the resulting combination of cumulative delays (308) forms said path delay statistical distribution.

13. Computer program product directly loadable into a memory of a computing device, comprising software code portions for performing the steps of the method of any one of the claims 1-10 when executed on said computing device.

14. Computer readable non-volatile storage medium containing the computer program product according to claim 13.
